(19) **Europäisches Patentamt / European Patent Office / Office européen des brevets**

(11) **EP 1 923 709 B1**

(12) **EUROPEAN PATENT SPECIFICATION**

(45) Date of publication and mention
of the grant of the patent:
**16.05.2012 Bulletin 2012/20**

(51) Int Cl.:
**G01R 15/18** (2006.01)

(21) Application number: **06381049.3**

(22) Date of filing: **16.11.2006**

(54) **Active linear current transducer**

Aktive lineare Stromwandler

Capteur de courant linéaire actif

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**21.05.2008 Bulletin 2008/21**

(73) Proprietor: **Cirprotec, S.L.**
**08223 Terrassa (ES)**

(72) Inventor: **Pons Gonzalez, Carlos**
**08223 Terrassa (ES)**

(74) Representative: **Hernández Hernández, Carlos**
**Olten Patentes y Marcas**
**C/ Rocafort, 87 entlo. 4**
**08015 Barcelona (ES)**

(56) References cited:
**EP-A- 1 596 206       WO-A-00/72027**
**WO-A-02/08771        WO-A-98/48287**
**US-A1- 2003 137 388   US-A1- 2004 178 875**

## Description

### OBJECT OF THE INVENTION

The object of this invention is an active linear current transducer based on the principle of Rogowski sensors.

These transducers are used to measure alternating current, detecting the magnetic field caused by a current which circulates through a conductor without the need to have an electrical contact with the conductor.

The functioning principle of the Rogowski coils is based on the coil with an air core placed around the conductor in such a way that the magnetic field produced by the current, which flows through the conductor, induces voltage in the coil.

This active linear current transducer is also characterised, in addition to being based on the principle of Rogowski sensors, by the fact of being manufactured in a printed circuit board.

The transducer object of the invention is also characterised by the fact of integrating, jointly with the transducer, the electronics required for the amplification, integration, filtering, and measurement of quality parameters of the network as well as the system of autorange, storage, and transmission.

Consequently, this invention is circumscribed within the scope of the measurement devices used to measure alternating current and in a more specific way among those which are performed on a printed circuit board and base their measurement in the functioning principle of the Rogowski coil.

### BACKGROUND OF THE INVENTION

Until now, various devices have been used to measure alternating currents, which we shall briefly explain and comment.

One device used to measure alternating currents is the low resistance current shunt, which is the solution with the lowest cost to provide a simple reading with good precision. However for the measurement of currents with high precision, parasite inductances are presented in the shunt and although they affect the magnitude of the impedance at relatively high frequencies, it is sufficient to cause a significant error at a low power factor.

Given that its measurement principle is based on the passage of the current through a resistive element, and since the power loss is proportional to the square of the current which passes through the resistance, it is not applicable among the power meters with high current, on the other hand, faced with short circuits and surge currents, the response is the aperture of the current loop so that the equipment depending on loop remain without current.

Another solution is based on a current transformer, which uses the principle of current induction, transforming a greater primary current into a secondary current of lower value. Its disadvantage is that the ferric material of the core can be saturated when the primary current is very high or when there is a continual current component in the current, causing significant errors in the final measurement of the current level.

Once the core has been saturated, its precision will deteriorate unless the core is demagnetized again, where the main circuit must be opened, disconnecting equipment or power supply for its installation. On the other hand, the measurement ranges obtained are narrow, where several transformers are required to cover levels from tens to thousands (kilo) of amps.

Additionally, the measurement with current transformers presents a limited response at low frequencies, where it is not possible to perform an analysis of the network quality.

Another solution for the measurement of alternating current similar to the above is by means of a current transformer with an open core, which presents the advantage of being easily installable with having to open the circuit to be measured, nevertheless, it obtains lower precision; in addition it is triple the cost for the closed core transformer.

Another method to measure alternating currents is by means of a sensor with the Hall effect which has an excellent response in frequency and is qualified to measure very high currents, however it presents a high drift by temperature and the need to rely on external control circuits, normally located several meters from the sensor, also presenting a relatively high cost.

Another solution are the coils with air core or the Rogowski coils, which do not require any contact with the conductor to measure the current, where its measurement is based on the coil with air core placed around the conductor so that the magnetic field produced by the current which flows through the conductor, induces voltage in the coil. Its advantage is the minimum influence of currents and external fields, notwithstanding it is not suitable for the measurement of Currents at the milliamp level at low frequencies; on the one hand, their manufacture requires a high degree of precision which involves a high production cost. On the other hand, it requires the integration of its output signal to obtain the value of the current, thus it requires the use of an external device, which means loss by affectation and attenuation by interferences. Another recognized solution to measure alternating currents is a current sensor with equal areas, consisting of two symmetrical layers where each of them is comprised by two concentric coiled sections in an opposing direction, so that the interior and exterior areas are equal, which is designed on a printed circuit board, obtaining an output signal of voltage proportional to di/dt the same as the Rogowski coils, nevertheless it is an intrusive sensor since for its functioning, the current must circulate through the sensor, which requires opening the circuit to be measured. Another drawback of this measurement method is the narrow measurement range from tens to hundreds of amps. In addition, given that it is connected in series, in the case of short circuit or surge currents, it would cause the breakage of the sensor and the passage of current in the circuit to be measured.

It is known in the state of the art a device with wide pass band for measuring electric current intensity in a conductor as the one disclosed at WO 9848287 where the current to be measured passes in a conductor enclosed with a Rogowski coil and in the proximity thereof are arranged several magnetic field detectors (3). The sum of the signals from these detectors, formed in the device, and the signal supplied by the Rogowski coil are applied to a signal processor. The processor (7) comprises, for example, a first order delay device connected to the Rogowski coil output and means for amplifying/ reducing the signals followed by adding means, the delay time constant and the amplifying/reducing factors being selected so that the device output signal is proportional to the intensity of the current to be measured in a very wide frequency range, i.e. from 0 to more than 10 MHz.

It is also known a printed circuit board-based current sensor as the one disclosed in US 2003/137388 where is provided a slotted current acquisition coil according to the Rogowski principle in which the printed circuit board base of the measuring coil can be opened to insert an electrical conductor to be measured without having to interrupt the latter. To this end, the two printed circuit board segments linked together by a hinge are opened. Twisting a single-piece printed circuit board also opens the arrangement for inserting the conductor to be measured.

In WO 00/72027 is disclosed an electrical current sensor for measuring a time-varying electrical current (Im) in a portion of primary conductor, the sensor including a sensor conductor comprising first and second ends for connection to a signal processing circuit, a first conductor portion extending from the first end and having a plurality of windings to form a first coil portion, and a second conductor portion returning to the second end.

In document EP 1596206 is disclosed a device which has three coils connected in series and forming a closed polygonal outline designed to surround a conductor to perform current measurement. The local inductance of one of ends of the coils is greater than the local inductance towards a central part of the coils. The coils' ends comprise of larger number of turns of wire per unit length than the number of turns of wire per unit length towards central part of the coils.

Consequently, having explained the different known methods for the measurement of alternating currents and the disadvantages involved with each of them, the object of this invention is the development of a measuring system of alternating currents which present the following features:

- measurement in an extensive range of currents from mA to tens of kA.
- the adjustment of the signal is performed in an integral way in the transducer.
- The transducer possesses a high sensitivity.
- It is equipped with variable geometry and adaptation according to the application.
- It presents a low manufacture cost.

## DESCRIPTION OF THE INVENTION

The invention proposed for the active linear current transducer permits the measurement of alternating current which circulates through a conductor without possessing an electrical contact with it, whose functioning is based on the Rogowski coil, and the coil is built on a printed circuit board in addition to integrating the electronics required for the adjustment of the measured signal.

The adjustment electronics of the measured signal will be responsible for the integration, filtering, and measurement of quality parameters of the network as well as the system of autorange, storage, and transmission.

The integration of the electronics for the signal adjustment eliminates the problem of the signal attenuation and capture of interferences in the wire which would extend from the sensor to the electronics, in the case that it were separated.

The transducer is designed in a multi-layer printed circuit board geometrically compensated to reject the influence of external fields.

The transducer can be presented in two ways, as a closed or open contour, where for the latter case, a compensation method has been developed for the negative effect of space or "gap" created in the joint of the parts when closed, by means of the inclusion of a layer of material whose relative permeability is very high, so that It creates an increase of the field induced in the points of the joint where the planes of this material have been deposited.

The geometry or form which the transducer can present both in the closed as well as the open configuration can be any of the potential forms which the designer can imagine, which supposes no limitation for the specific form which the transducer adopts.

The transducer with the open contour is ideal for the applications in which it is not possible to open the primary or to do so, involves a very high cost

Thanks to the integration of the adjustment electronics for the measured signal, it is possible to possess a signal from the transducer output which is suitable for the measurement with standard devices such as voltmeters, oscilloscopes, data acquisition systems, high precision measurement exchanges, whose aim is the control and supervision of the main electrical parameters in single-phase and/or three-phase networks among others.

In addition, the transducer does not suppose any negative effect on the primary circuits since the impedance injected in the active transducer is only a few Henry-peaks thus there is no loss of power.

Another advantage derived from the active linear transducer object of the invention is that it permits the measurement of alternating currents in a wide range, which extends from mA to hundreds of KA, furthermore, given its non-intrusive nature in relation to the circuit which it will measure, it provides a measurable response in the case of short circuits or surge current, thus it is possible to take protection measures preventing adverse effects on the primary, which is not affected by the fact that it is galvanically insulated from the primary.

On the other hand, since it does not have an iron core which can be saturated, it presents a high linearity when high intensities are measured thus it is capable of measuring from a few mA, until various hundreds of KA.

Derived from the fact that it lacks an iron core, the phase displacement error is very small and does not depend on the intensity; a drawback which is present in the current transformers.

Given that the transducer of this invention does not measure continual current, as a result it can measure small alternating currents in the presence of components with continual currents. On the other hand, its extensive bandwidth allows it to work in high and low frequencies.

Since the transducer is manufactured on a printed circuit board and insulated by means of a housing, there is no risk of degradation of the properties of the sensor in relation to the measurement, presenting an ample stability against temperature.

Due to the fact indicated above that transducer is manufactured on a printed circuit board, it has perfect control of the density of the turns, of their section and layout according to the application, which means all the parameters that condition the output level of the sensor, which can obtain transducers that extend from a few centimetres until hundreds, although the limit is provided by the manufacturing process of the printed circuit board.

The printed circuit board in which the transducer is manufactured consists of at least three layers, two ends which configure the turns of the coil, and a central return layer in the electrical direction opposite that of the coil which makes it possible to eliminate the influence of external fields. In an equal way, the geometry of the transducer is designed with the objective to minimize the influence of the conductor position in the output signal.

The end layers which configure the turns of the coil are connected by means of several conductor paths which go through the central return layer.

In addition to the three described layers, the transducer can be equipped with an additional layer of high relative permeability material with which it manages to increase the sensitivity of the entire sensor, which can measure an extensive range of alternating current values from mA until kA, where this intermediate layer of high permeability material can be increased in specific points by means of greater planes of the same material, as for example for the control of the spaces or "gaps" which are created in the open transducers.

## EXPLANATION OF THE DRAWINGS

To complement the description which will be performed and with the aim to facilitate greater understanding of the characteristics of the invention, a set of plans has been attached to this descriptive report, where the most significant details of the invention are represented in its figures in an illustrative but not limited way.

Figure 1 shows the representation of the layers that comprise the printed circuit board which serve for the construction of the transducer.

Figure 2 is a detailed representation of the section of the printed circuit board where the different details of the set of turns are observed.

Figure 3 is a representation where one observes the representation of the approximate area of each turn.

Figure 4 is a symbolic representation of the set of a transducer with an open contour.

Figure 5 shows the housing of the transducer in an implementation in an open contour.

Figure 6 shows the detailed representation of the connections of each of the sections of the transducer in its implementation in an open contour.

Figure 7 shows the representation of the blocks that comprise the electronics of the linear active transducer object of the invention.

## PREFERENTIAL IMPLEMENTATION OF THE INVENTION

In view of the aforementioned figures, the preferential implementation mode of the invention and the explanation of the drawings are described below.

As mentioned above, the active linear current transducer is characterised, by the fact of being constructed in a printed circuit board and by the fact of integrating the electronics required for the signal processing inside the same housing.

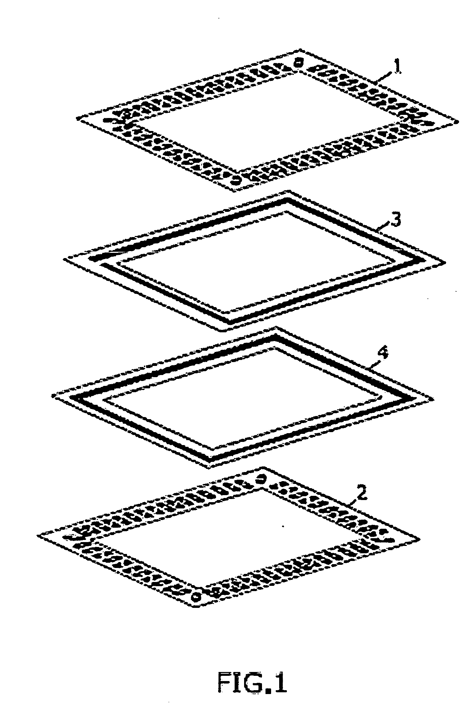

In figure 1, we can observe in an implementation of the invention, the different layers that comprise the printed circuit board on which the transducer is built. One layer is the layer (1) of upper turns, another of the layers, is the layer (2) of lower turns between which it possesses a return layer (3) laid out in the electrical direction opposite that of the coil, which makes it possible to eliminate the influence of the external fields. If one wishes, it is possible to possess an additional fourth layer (4) of relative high permeability material which manages to increase the sensitivity of the entire sensor, which can measure from mA, until several hundreds of kA.

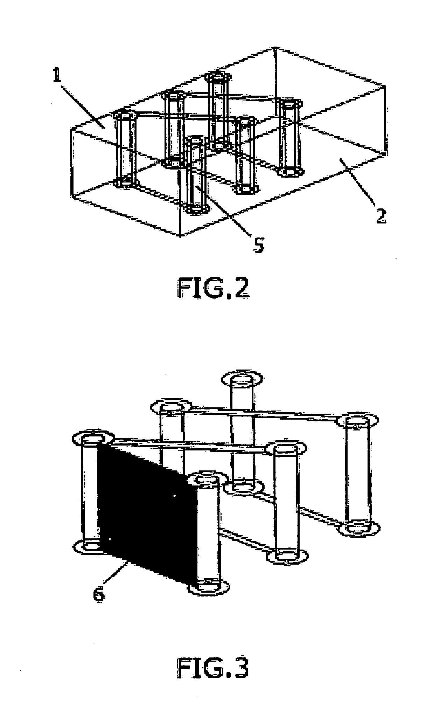

Figure 2 shows how the connection is performed between the upper tayer (1) and the lower layer (2), implemented by means of conductor paths (5) which extend from the upper layer (1) to the upper layer (2). The voltage level of the sensor output is equal to:

$$V_{sensor} = d\Phi / dt = \mu\, n\, A\, di/ dt$$

Where:

- p expresses the permeability.
- n the number of turns
- A the area of each turn.

Since the transducer is manufactured on a printed circuit board, we have control over all the parameters which condition the level of the sensor output, as figure 3 shows, where the area (6) occupied by a turn is observed in a clear way.

On the other hand, since the electronics responsible for the conditioning of the signal are integrated under the same housing as the sensor, the measurement will not be affected by interferences, attenuation, or inductive effects, since the distance to the electronic circuits is minimal.

The integration of the conditioning electronics of the signal obtained by the sensor, can be performed on the same printed circuit board in which the sensor is built, or on a different but adjacent board. In any of the implementation forms expressed, both the sensor and the conditioning electronics of the signal are housed under the same housing.

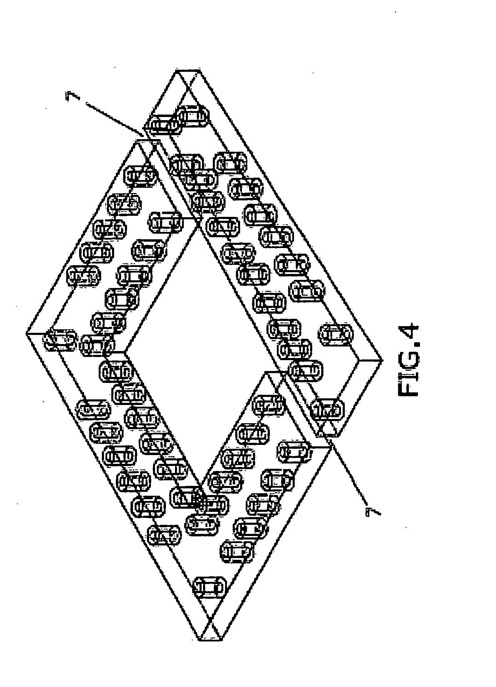

In figure 4, we observe the transducer sensor in an implementation in an open contour, where it is possible to observe a separation or "gap" (7) between the two sections that comprise the transducer.

The transducer's configuration in open contour makes it possible to insert the transducer in a circuit to be measured without interrupting it; nevertheless this configuration of two parts or sections leads to the negative effect of a loss of sensitivity in the joints since it creates a separation or "gap". With the aim to counteract this effect, it proceeds to increase the relative permeability in the joints, this is performed based on the widened planes starting from the return plane of the intermediate layer of the high permeability layer, so that magnetic induction is greater thus compensating the loss of sensitivity. It is also possible to create more intermediate levels and increase the relative permeability with new planes.

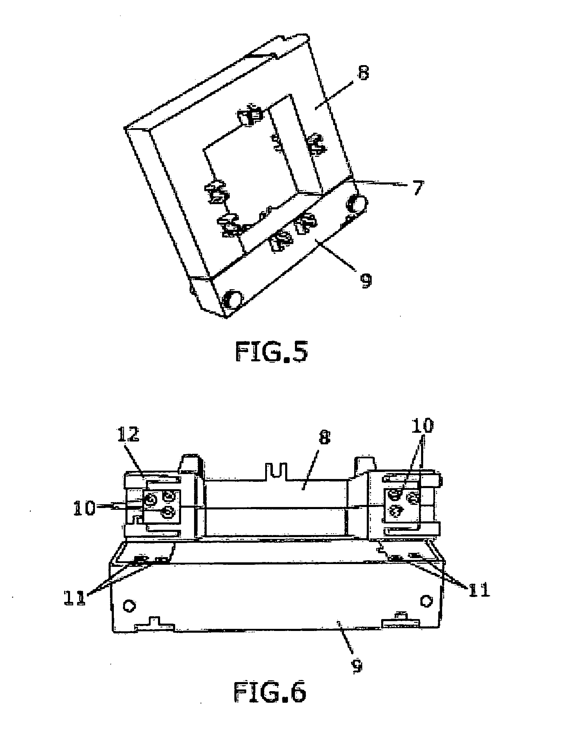

Figure 5 shows the transducer in an open contour configuration, which is comprised by two parts or sections (8) and (9) between which a separation or "gap" (7) is defined. Figure 6 shows how on one of the sections, specifically section (8) is equipped with a pair of projecting elements (10) in each one of the contact surfaces, which fit in several complementary perforations (11) performed on the contact surfaces of the section or part on which it is joined. The housing of both sections is equipped with several joint elements (12) which allow one section to fit in the other.

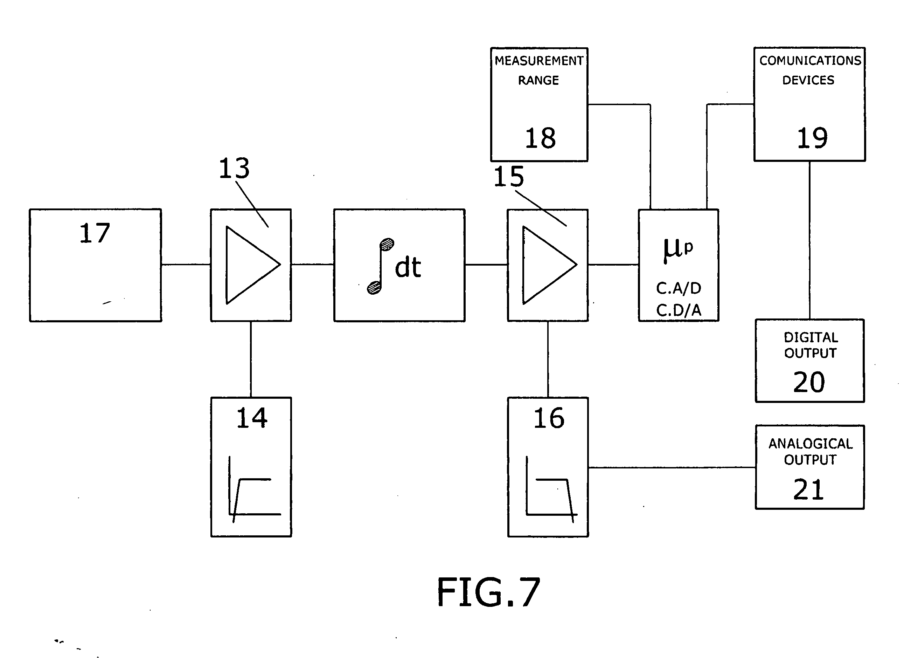

Finally, figure 7 shows the main elements which comprise the electronics integrated jointly with the sensor comprising the transducer object of the invention and responsible for the conditioning of the signal. This electronics, after the reception of the signal (17) by the sensor, is equipped with an amplifier stage (13) with a high-pass filter, followed by an integrator stage which follows another amplifier stage (15) jointly with the low-pass filter (16). Coupled with this last stage, there are several coupling devices of the measurement range (18) jointly with other communication devices (19) which provide a digital output (20) and another analogical output (21).

It is not considered necessary to make this description more extensive in order for any expert in this matter to understand the scope of the invention and the advantages derived from it.

The materials, form, size, and layout of the elements shall be susceptible to variation always when they do not alter the essential nature of the invention.

The terms in which this report has been described must always be taken in their most extensive and not limitative sense.

## Claims

1. An active linear current transducer based on the principle of Rogowski sensors **characterised in that** a coil is built on a printed circuit board, integrating the electronics of the signal conditioning in a joint way with the coil, the printed circuit board is equipped with three layers (1,2,3), the two outer layers (1,2) comprise the upper and lower turns of the coil, connected by means of conductor paths (5) and a central layer (3) which provides a return in the opposite direction of the coil, additionally the printed circuit board is equipped with another layer (4) of very high relative permeability, placed between the return layer (3) and one of the layers (1,2) of the turns and presenting a configuration in an open contour having a gap (7), **characterized in that** the negative effect of the gap (7) is cancelled by an increase of the induced field by increasing relative permeability in the ends of the transducer joints.

2. The active linear current transducer according to claim 1, **characterised in that** the transducer is comprised by two parts (8, 9) between which a gap (7) is defined, and **in that** on one of the parts (8,9) there is a pair of projecting elements (10) in each one of the contact surfaces, which fit in several complementary perforations (11) performed on the contact surfaces of the part on which it is joined, and **in**

**that** in the housing of both parts is equipped with several joint devices (12) which allow one part to fit in the other and remain retained.

3. The active linear current transducer according to any of the above claims **characterised in that** the electronics responsible for the conditioning of the signal is integrated on the same printed circuit board on which the coil is integrated.

4. The active linear current transducer according to any of the above claims **characterised in that** the electronics responsible for the conditioning of the signal is integrated on a different printed circuit board than the coil, remaining under the same housing.

5. The active linear current transducer according to claims 3 or 4, **characterised in that** the conditioning electronics of the signal are responsible for the integration, amplification, filtering, measurement of the parameters of the network as well as the system of autorange, storage, and transmission.

**Patentansprüche**

1. Ein aktiver linearer Stromwandler, basierend auf dem Prinzip der Rogowski-Sensoren, **dadurch gekennzeichnet, dass** eine Spule auf einer Leiterplatte montiert ist, welche die Signalverarbeitungselektronik zusammen mit der Spule integriert; die Leiterplatte ist mit drei Schichten ausgestattet (1, 2, 3); die beiden äußeren Schichten (1, 2) umfassen die oberen und unteren Windungen der Spule, welche durch Leiterbahnen (5) verbunden sind, sowie eine mittlere Schicht (3), die in die entgegengesetzte Richtung der Spule zurückführt; zusätzlich ist die Leiterplatte mit einer weiteren Schicht (4) mit sehr hoher relativer Permeabilität ausgestattet, welche zwischen der zurückführenden Schicht (3) und einer der Schichten (1,2) der Windungen liegt und eine offene Konturgebung mit einem Spalt (7) aufweist, **dadurch gekennzeichnet, dass** die negative Wirkung des Spaltes (7) durch eine Erhöhung des induzierten Feldes aufgehoben wird, indem die relative Permeabilität an den Enden der Wandlerverbindungen erhöht wird.

2. Der aktive lineare Stromwandler nach Anspruch 1, **dadurch gekennzeichnet, dass** der Wandler aus zwei Teilen besteht (8, 9), zwischen denen ein Spalt (7) festgelegt ist, und dass auf einem der Teile (8, 9) ein Paar von vorspringenden Elementen (10) an jeder der Kontaktflächen existiert, das in mehrere komplementäre Perforierungen (11) an den Kontaktflächen des Teils, mit dem es verbunden wird, passt, und dass das Gehäuse der beiden Teile mit mehreren Verbindungsvorrichtungen (12) ausgestattet ist, die es ermöglichen, dass ein Teil in das andere eingepasst und festgesteckt wird.

3. Der aktive lineare Stromwandler nach einem der obigen Ansprüche, **dadurch gekennzeichnet, dass** die Elektronik für die Signalverarbeitung auf der gleichen Leiterplatte integriert ist, auf der die Spule montiert wird.

4. Der aktive lineare Stromwandler nach einem der obigen Ansprüche, **dadurch gekennzeichnet, dass** die Elektronik für die Signalverarbeitung auf einer anderen Leiterplatte als die Spule, jedoch in demselben Gehäuse integriert ist.

5. Der aktive lineare Stromwandler nach den Ansprüchen 3 oder 4, **dadurch gekennzeichnet, dass** die Signalverarbeitungselektronik für die Integration, Verstärkung, Filterung und Messung der Parameter des Netzwerkes sowie das System zur automatischen Bereichswahl, Speicherung und Übertragung zuständig ist.

**Revendications**

1. Un capteur de courant linéaire actif basé sur des sondes du principe de Rogowski **caractérisé en ce qu'**une bobine est fabriquée sur une plaque de circuit imprimé, intégrant l'électronique du signal conditionnant de manière jointe avec la bobine ; la plaque de circuit imprimé est équipée de trois couches (1, 2, 3), les deux couches extérieures (1, 2) comprenant les deux tours le plus élevé et le plus bas de la bobine, connectés au moyen de voies de conducteurs (5), et d'une couche centrale (3) qui apporte un retour dans la direction inverse de la bobine ; en outre, la plaque de circuit imprimé est équipée d'une autre couche (4) d'une perméabilité relative très élevée, placée entre la couche de retour (3) et une autre des couches (1, 2) des tours et présentant une configuration dans un contour ouvert avec un trou (7), **caractérisé en ce que** l'effet négatif du trou (7) est annulé par une augmentation du champ induit augmentant la perméabilité relative dans les extrémités des joints du capteur.

2. Le capteur de courant linéaire actif conformément à la revendication 1, **caractérisé en ce que** le capteur est composé de deux parties (8, 9) entre lesquelles un trou (7) est défini, et **en ce que** dans l'une des parties (8, 9) il y a une paire d'éléments de projection (10) dans chacune des surfaces de contact, qui s'intègre dans plusieurs perforations complémentaires (11) en agissant sur les surfaces de contact de la partie sur laquelle il est relié, et **en ce que** le logement des deux parties est équipé de plusieurs dispositifs de jointure (12) qui permettent à une partie de s'intégrer dans une autre partie et d'y demeurer.

3. Le capteur de courant linéaire actif conforme à l'une quelconque des revendications ci-dessus **caractérisé en ce que** le responsable électronique pour le signal conditionnant est intégré sur la même plaque de circuit imprimé que celle où la bobine est intégrée.

4. Le capteur de courant linéaire actif conforme à l'une quelconque des revendications ci-dessus **caractérisé en ce que** le responsable électronique pour le signal conditionnant est intégré sur une plaque de circuit imprimé différente de celle de la bobine, demeurant sous le même logement.

5. Le capteur de courant linéaire actif conforme aux revendications 3 ou 4, **caractérisé en ce que** l'électronique du signal conditionnant est responsable de l'intégration, de l'amplification, du filtrage, de la mesure des paramètres du réseau aussi bien que du système d'auto-variation, de stockage et de transmission.

FIG.1

FIG.2

FIG.3

FIG.4

EP 1 923 709 B1

FIG.5

FIG.6

COMUNICATIONS DEVICES
19

DIGITAL OUTPUT
20

ANALOGICAL OUTPUT
21

μp
C.A/D
C.D/A

MEASUREMENT RANGE
18

15

16

$\int dt$

13

14

17

FIG.7

**EP 1 923 709 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 9848287 A
- US 2003137388 A
- WO 0072027 A
- EP 1596206 A